# EUROPEAN PATENT APPLICATION

(11) **EP 3 182 456 A1**
(43) Date of publication of application: **21.06.2017**
(21) Application number: 16203269.2
(22) Date of filing: 09.12.2016
(51) Int. Cl.: H01L 27/30, H01L 51/00, H01L 51/44, H01L 51/42

(54) **METHOD OF SCREEN PRINTING IN MANUFACTURING AN IMAGE SENSOR DEVICE**

(30) Priority: 18.12.2015 US 201562386999 P; 15.08.2016 US 201615237447; 05.12.2016 US 201615369455
(71) Applicant: DPIX, LLC, Colorado Springs, CO 80916 (US)
(72) Inventor: RODRIQUEZ, Robert, Colorado Springs, CO Colorado 80918 (US); O'ROURKE, Shawn Michael, Colorado Springs, CO Colorado 80906 (US)
(74) Representative: Smaggasgale, Gillian Helen

(57) **Abstract**

A method of manufacturing an image sensor device includes providing a metalized thin film transistor layer (106) on a glass substrate (102); forming an inter-layer dielectric layer (112) on the metalized thin film transistor layer (106); forming a via through the inter-layer dielectric layer (112); forming a metal layer (120 - 126) on the inter-layer dielectric (112) for contacting the metalized thin film transistor layer (106); forming a bank layer (128) on the metal layer (120-126) and the inter-layer dielectric layer (112); forming a via through the bank layer (128); forming an electron transport layer (136) on the bank layer (128) and within the bank layer via for contacting an upper surface of the metal layer (120-126); forming a bulk hetero-junction layer (138) on the electron transport layer (136); forming a hole transport layer (140) on the bulk hetero-junction layer (138); and forming a top contact layer (142) on the hole transport layer (140). The bulk hetero-junction layer (138) and/or the top contact layer (142) are applied using a screen printing technique.

## Description

### RELATED APPLICATIONS

The present application claims priority benefit to U.S. non-provisional patent application ("Copending Non-Provisional Application"), serial no. 15/369,455, filed December 5, 2016, which is a continuation-in-part of U.S. non-provisional patent application ("Copending Non-Provisional Application"), serial no. 15/237,447, filed on August 15, 2016 and claims priority to U.S. provisional patent application ("Copending Provisional Application"), serial no. 62/386,999, filed on December 18, 2015. The disclosures of the Copending Applications are hereby incorporated by reference in their entirety.

### BACKGROUND OF THE INVENTION

### 1. Field of the Invention.

The present invention generally relates to image sensor devices, and, more particularly, to a method for manufacturing the image sensor devices.

### 2. Relevant Background.

Organic semiconductor materials are known in the art and have many potential advantages over traditional amorphous silicon-based semiconductor materials. Organic semiconductor materials can be used in the manufacture of image sensor devices. The organic chemicals used in the manufacturing process can be tailored to be sensitive to different frequencies ranging from ultraviolet to infrared. Chemical films produced with these organic chemicals have lower stress and lower processing temperatures, which can be advantageous when working with flexible substrates.

Manufacturing of individual organic diodes on a substrate to create photo-sensing arrays remains a challenge. Being able to deposit the individual films in a repeatable, robust, efficient, and relatively inexpensive manner is still extremely challenging for large-scale image sensor devices built on a glass or flexible substrate. It would therefore be desirable to provide a manufacturing method for an image sensor device that can overcome the above restrictions and limitations.

### SUMMARY OF THE INVENTION

There are many methods of applying various Organic Photodiode ("OPD") layers including slot-die coating, inkjet printing, spin-coating doctor blading, evaporation, and screen printing. Conventional approaches for the application of the OPD layers on a large-scale substrate use slot-die coating for the active layer, slot-die coating or evaporation for the top contact layer, and a combination of slot-die coating and chemical vapor deposition of the barrier layer. While many of these manufacturing techniques have shown successful results, they are still relegated to small-sized examples and are limited to one sensing array layout on the substrate.

Screen printing of organic photodiode layers, while generally viewed as not being an appropriate manufacturing technique, has many potential advantages over other methods of manufacturing large sensor arrays including the ones mentioned above. Unlike slot-die coating, the screens used in screen printing are easy to clean as well as to change from one production layout to another. Screen printing equipment and screen costs are cheaper than other equipment used for manufacturing OPDs. In addition, the method of manufacturing OPDs using screen printing techniques offers a repeatable, robust and cost efficient manufacturing process over other methods currently being used. Historically, screen printing of complex organic electronic arrays has been ignored due to perceived limitations of film thickness limits, uniformity, and resolution. The method of the present invention addresses these concerns at least in part by developing process recipes using screen printer screens that are matched to the viscosities of the chemicals being used.

According to an embodiment of the invention, a method of manufacturing an image sensor device includes providing a metalized thin film transistor layer form on a glass substrate; forming an inter-layer dielectric layer on the metalized thin film transistor layer; forming a via through the inter-layer dielectric layer; forming a metal layer on an upper surface of the inter-layer dielectric and within the inter-layer dielectric layer via for contacting the metalized thin film transistor layer; forming a bank layer on an upper surface of the metal layer and the inter-layer dielectric layer; forming a via through the bank layer; forming an electron transport layer on an upper surface of the bank layer and within the bank layer via for contacting an upper surface of the metal layer; forming a bulk hetero-junction layer on an upper surface of the electron transport layer; forming a hole transport layer on an upper surface of the bulk heterojunction layer; and forming a top contact layer on an upper surface of the hole transport layer, wherein at least one of the bulk hetero-junction layer or the top contact layer are applied using a screen printing technique.

The image sensor device and method of manufacturing is fully described below with various embodiments and examples, and is illustrated in the following drawings.

### BRIEF DESCRIPTION OF THE DRAWINGS

FIG. 1 illustrates, in a cross-sectional view, a portion of an array from an image sensor device including a transistor and a photodiode manufactured using the process of the present invention;
FIGS. 2A-2B illustrate, in cross-sectional views, a nozzle and shim used in the manufacture of an image sensor device according to the prior art;
FIGS. 3A-3B illustrate, in cross-sectional and plan views, the application of an OPD layer, according to a prior art method using the nozzle and shim shown in FIGS. 2A-2B;
FIGS. 4-7 illustrate manufacturing steps for the application on an OPD layer, according to the method of the present invention;
FIG. 8 illustrates the transmission of light with respect to a silver film thickness deposited on a glass substrate;
FIG. 9 illustrates the transmission of light with respect to a conductive film deposited on a glass substrate according to the present invention; and
FIG. 10 illustrates the transmission of light with respect to silver nanowire ink deposited on a glass substrate according to the present invention.

### DETAILED DESCRIPTION OF THE PREFERRED EMBODIMENTS

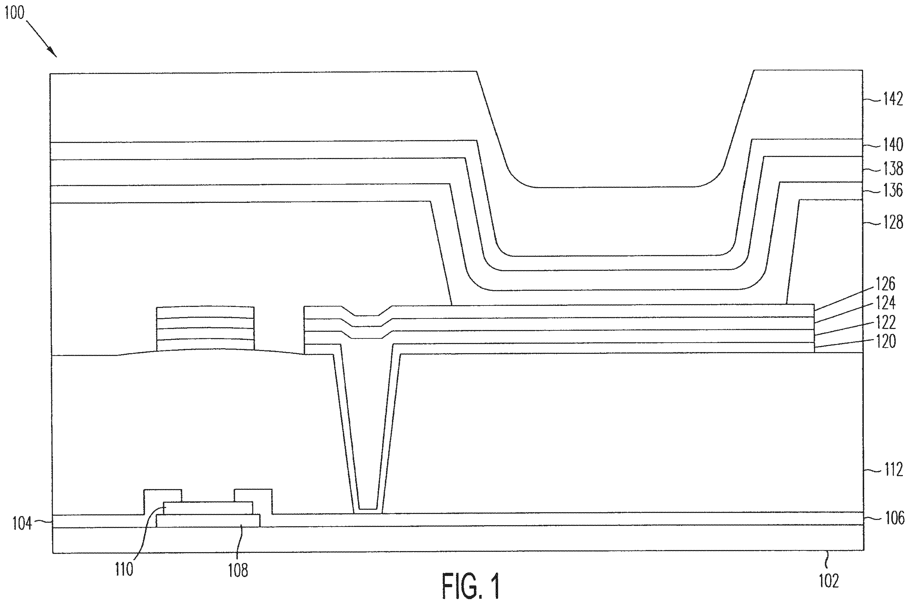

An Organic Photo-Diode ("OPD") manufacturing process for an embodiment of the invention is described below with respect to drawing FIG. 1.

Figure 1 shows a portion of a Thin-Film Transistor ("TFT") array 100 including a glass substrate 102, a data line 104, a line 106 for coupling to the photodiode stack to the data line of the sensor array, a gate 108, and an island 110. The substrate 102 is typically glass, but a plastic substrate (using polyethylene naphthalate, polyethylene terephthalate, or polyimide) can also be used. The material for lines 104 and 106 is typically Chrome ("Cr") with a nominal thickness of about 500 Angstroms. The material is deposited using Physical Vapor Deposition ("PVD"). The material for gate 108 can include Aluminum ("Al") with a nominal thickness of about 1300 Angstroms combined with Titanium Tungsten ("TiW") with a nominal thickness of about 200 Angstroms. The material for gate 108 can be applied using Physical Vapor Deposition ("PVD"). The gate 108 dielectric material can be Silicon Nitride ("SiN") having a nominal thickness of about 3300 Angstroms, amorphous Silicon ("a-Si") having a nominal thickness of about 500 Angstroms, and SiN having a nominal thickness of about 1500 Angstroms. The material for the gate 108 dielectric can be applied using Plasma-Enhanced Chemical Vapor Deposition ("PECVD"). The active portion (source-drain, or island 110) of the TFT is formed of microcrystalline Silicon ("µc-Si silicon") having a nominal thickness of about 500 Angstroms and a Chromium layer ("Cr") having a nominal thickness of about 800 Angstroms. The island 110 can be formed using both PECVD and PVD.

Figure 1 further shows the application of an Inter-Layer Dielectric ILD film layer 112 (ideal thickness 0.5 um to 2.0 um) onto the TFT layer of FIG. 1 using PECVD. The PECVD process temperature is ideally between 200 °C and 300 °C. ILD materials can include SiON or SiO2 and SiN.

Figure 1 further shows the deposition of a metal stack including layers 120, 122, 124, and 126. The metal layers are patterned into two patterned stacks to form the light shield for the TFT and also to form the bottom contact, or cathode of the photodiode. Following etch, the metal interconnect layer is deposited by PVD/sputtering. This process comprises using a quad-layer metal stack, beginning from the bottom layer 120, of TiW, Al, TiW, and ITO or Chrome, Al, TiW, and ITO. Typical film thickness is 200A to 1000A for the first layer 120, 1000A to 10000A for the Al layer 122, 200A to 1000A for the third layer 124, and 100A to 800A for the fourth layer 126. All depositions are performed at a temperature of less than 100 °C. Alternatives to this approach include replacement of Cr or TiW with other refractory metals (examples include Mo, MoW, Ti, etc.), alternative conductors from Al (examples include Cu, Al:Nd, Al:Si, Ag, etc.). Alternatively the fourth layer 126 can be replaced with a conductive oxide, including but not limited to ITO, IGZO, IZO, ITZO, or AZO.

Figure 1 further shows the deposition of the bank layer 128, which can be a resin material. The bank layer 128 is deposited on the ILD layer 112 and the patterned metal layers 120, 122, 124, 126, using a solution process (i.e. extrusion, slot die, spin coating, spray coating or inkjet). The ideal thickness of the bank layer 128 is between 1.0 um to 6.0 um. The bank layer 128 is deposited at an ambient temperature followed by a soft bake (to remove solvents) at T = 50 °C to 100 °C. The bank layer 128 materials may include, but are not limited to, Dow Chemical Cyclotene 6100 series (or variants thereof), Honeywell PTS series, Microchem SU-8, TOK TPIR PN-0371D or other such resin materials that are known in the art. The bank material described above provides excellent planarization (>90%) over the entire substrate.

Figure 1 further shows the deposition of the Electron Transport Layer ("ETL") 136. The ETL layer 136 has the function of tuning, or bridging the work function of the ITO (cathode) with the work function of the bulk heterojunction layer material. The material can be PEIE (ethoxylated polyethylenimine) and is ideally deposited onto each individual array. The ETL material can be applied by spin-coating, spray-coating or an inkjet process. The solution coats or fills, depending on the thickness deposited, each pixel well. Typical thicknesses range from 5 nm to 400 nm. The ETL layer 136 is then baked on a hot plate in a nitrogen environment for 5 to 20 minutes between 100 °C and 130 °C. If an alternate material is used for layer 126, then this ETL layer 136 can be skipped in the process. The alternate material becomes the ETL layer.

Figure 1 further shows the deposition of the Bulk Heterojunction Layer ("BHJ") 138. The BHJ layer 138 has the function of converting light into electrical charge. The BHJ consists of a donor/acceptor material mixed in a solvent or solvents. The electron donor material is typically, but not exclusively, poly(3-hexylthiophene) ("P3HT") and the electron acceptor is typically phenyl-C61-butyric acid methyl ester ("PC61BM" or "C60"). The BHJ material is deposited onto the ETL layer 136. The BHJ material can be applied by screen printing, slot-die coating, spin-coating, spray coating or by inkjet. The solution coats or fills, depending on the thickness deposited, each pixel well. Typical thicknesses range from 100 nm to 1000 nm. The BHJ layer 138 is then baked initially for 2 to 8 minutes between 50 °C to 80 °C to drive the solvent out slowly. Afterwards, the BHJ layer 138 is baked in a nitrogen environment or in vacuum between 110 °C and 130 °C for 3 to 10 minutes.

Figure 1 further shows the deposition of the Hole Transport Layer ("HTL") 140. The HTL layer 140 has the function of tuning, or bridging the work function of the BHJ with the work function of the anode layer, or top contact layer material and is ideally poly(3,4-ethylenedioxythiophene) polystyrene sulfonate ("PDOT:PSS") and deposited onto the BHJ layer 138. The HTL material can be applied by spin-coating, spray-coating or an inkjet process. The solution coats or fills, depending on the thickness deposited, each pixel well. Typical thicknesses range from 5 nm to 400 nm. The HTL layer 140 is then baked on a hot plate in a nitrogen environment for 5 to 20 minutes between 100 °C to 130 °C. Alternate materials for the HTL layer can be molybdenum trioxide (MoO3). MoO3 is deposited by evaporation process.

Figure 1 further shows the deposition of the Top Contact Layer ("TC") 142. The TC layer 142 has the function of acting as the top contact, or anode of the photodiode and can be either a transparent conductive material, such as a different mixture of PDOT:PSS or silver nanowire and deposited onto the HTL layer 140. The TC material can be applied by screen printing, slot-die coating, spin-coating, spray coating or by an inkjet process. The solution coats or fills, depending on the thickness deposited, each pixel well. Typical thicknesses range from 50 nm to 1000 nm. The TC layer 142 is then baked initially for 2 to 8 minutes between 50 °C to 80 °C to drive the solvent out slowly. Afterwards, the TC layer 142 is baked in a nitrogen environment or in a vacuum between 110 °C and 130 °C for 3 to 10 minutes.

Further, with respect to FIG. 1, a grid bias is applied to the top contact TC layer 142 for proper electrical operation of the array. Layers 136 to 142 are not further patterned to create the individual pixels, as electrons impinging outside of the pixel wells are just absorbed and do not contribute to the individual pixel signals. A clear material that is compatible with layers 136 to 142 can be used as a moisture barrier and passivation layer (not shown).

According to the method of the present invention, one or both of the BHJ layer 138 or the TC layer 142 can be applied using screen printing deposition according to an embodiment of the method of the present invention.

For screen printing deposition of the BHJ layer 138, a screen would be loaded into a screen printer and chemically applied to the edge, or the beginning of the printed feature, as is explained in further detail below. Nominal speed for printing is 225mm/s to 280mm/s, the print gap is 4.5mm and screen mesh count is 460 threads/cm.

For screen printing deposition of the TC layer 142, the screen used for the BHJ application would be removed from the screen printer and the screen used the TC layer would be loaded. The corresponding chemical would be applied to the edge, or the beginning of the printed feature, as is explained in further detail below. Nominal speed for printing is 250 mm/s to 300 mm/s, print gap is 4.8 mm and screen mesh count is 83 threads/cm.

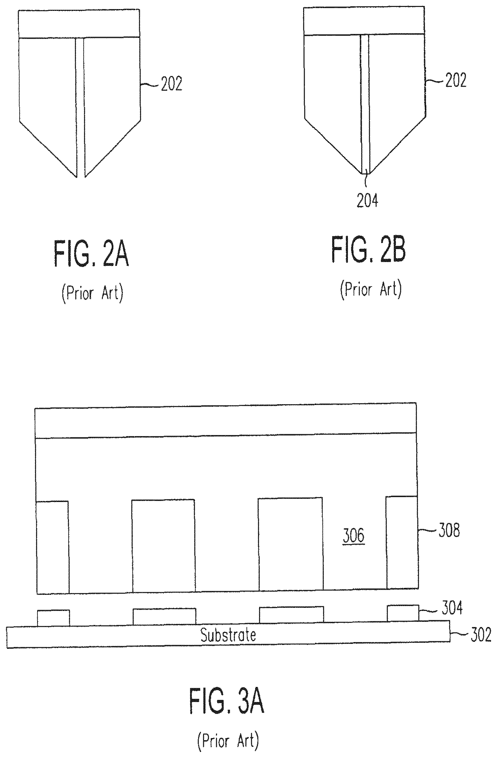

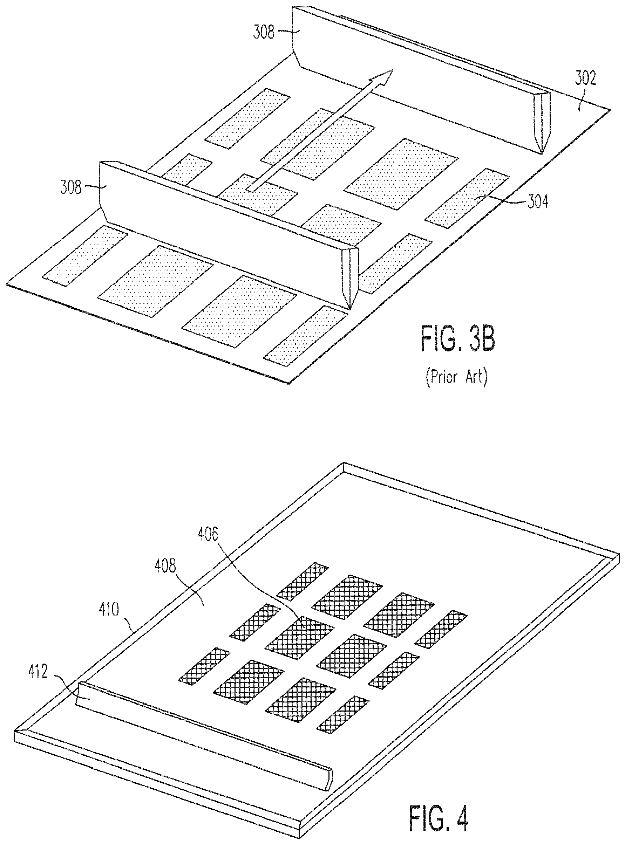

A known method of applying the photoactive ("PAL") layer in the photodiode (such as the BHJ layer 138) is to use slot-die coating. Slot-die coating uses a slit nozzle that forces chemicals between two pieces of stainless steel on the substrate. In between the two pieces of steel is a metal shim that allows only chemicals to be placed onto the substrate where it is open to flow. FIGS. 2A and 2B illustrate the nozzle and shim. FIG. 2A shows a nozzle 202, and FIG. 2B shows a nozzle 202 and corresponding shim 204. The shim 202 is placed in between the two vertical nozzle pieces, which allows the chemical to flow in only specified areas on the glass substrate. An example for applying an OPD layer to a substrate is shown with respect to FIGS. 3A and 3B.

Figure 3A shows a substrate 302, an OPD layer 304, a nozzle 308, and shim 306. Note that in FIG. 3A the view of the nozzle is a cross-sectional view taken along the length of the nozzle. FIG. 3B shows the substrate 302 and the OPD layer 304, and the nozzle 308 traversing from a first position to a second position in the process of depositing the OPD layer 304. In order to go from one OPD layout to another on the substrate 302, a user must take the nozzle 308 off of the coater gantry, or nozzle support structure, disassemble the nozzle 308 and replace the shim 306 to a different opening pattern. Then, the nozzle 308 must be put back onto the tool to manufacture the next product. Depending upon the product, the nozzle 308 must be re-qualified before depositing the OPD films on the substrate 302. The re-qualification phase can take a varied amount of time between hours and days depending on the uniformity demands of the product. In addition, the nozzle for a 730 mm by 920 mm glass substrate can weigh as much as 150 pounds and is not easily changed. A specialized crane is also required to remove the nozzle from the gantry.

The method of the present invention using a screen printer to apply the PAL layer, or the BHJ layer, as well as the TC layer offers many advantages over the other deposition methods for manufacturing OPD sensor arrays. The method of manufacturing OPD sensor arrays using screen printing techniques offers a repeatable, robust, and cost efficient manufacturing process over other method currently used. The screens are easy to clean as well as to change from one production layout to another. Screen printing equipment and screen costs are cheaper than other equipment used for manufacturing OPD sensor arrays.

The BHJ layer typically ranges from 200 nm to 2 um thick with the preferred thickness ranging from 300 nm to 400 nm. Uniformities for these thicknesses can be below 10%. These thicknesses and uniformities are easily deposited using slot-die coating, which is what most laboratory environments are using. Using a screen printer to apply a blanket coat between 200 nm to 500 um is not as easily achieved. One must use mesh screens with mesh counts between 195 threads/cm to 460 threads/cm. The openings allow limited chemical to flow through the screen. In addition, the thickness of the screen should be below 3 um. Lastly, the viscosity of the film must be optimized for the screens being used. Viscosities range from 30 cP to 150 cP. There are optimizing steps required to ensure the proper thickness and uniformity of the deposited film.

The printing recipe must have the correct printing squeegee speed, substrate-to-screen gap and squeegee print pressure. The printing speeds range from 100 thread/cm to 400 threads/cm, with nominal speeds ranging from 225 threads/cm to 300 threads/cm. The squeegee print pressures range from 3 kg to 10 kg of pressure, with nominal pressures ranging from 6 kg to 8 kg of pressure. The other aspect to ensuring the correct thickness and uniformity is the screen-to-substrate gap. This distance can range from 0.2 mm to 6 mm, with nominal gaps between 3 mm and 5 mm.

The top contact layer, TC, uses similar guidelines outlined for depositing the BHJ layer. There are two things to consider when depositing this layer using a screen printer, and that is the material that is being used for the TC layer and the thickness of the TC layer. For silver nanowire, the film must be less than 700 nm to ensure greater than 75% of the light will be transmitted to the BHJ layer. The same screens used for the BHJ layer can be used for the silver nanowire deposition. The viscosity of the silver nanowire is different, approximately 225cP.

Using transparent conductive ink as the TC layer requirs different screens in order to achieve the correct film thickness. This film typically is thicker than silver nanowire, ranging from 0.800 um to 1.6 um. The nominal thickness is between 0.9 um to 1.2 um. This thickness is required to ensure sufficient conductivity of the TC layer. This material allows a greater percentage of light (∼90%) to be transmitted to the BHJ layer. The viscosity of transparent conductive ink is typically 26K cP.

The application of the BHJ layer, using a screen printer is achieved by forcing chemicals through a screen mesh with a squeegee and onto the substrate. The screen is comprised of an aluminum frames glued to a screen mesh. An emulsion is then applied onto the mesh, covering the areas that are not allowed to transfer the chemical to the substrate. An example of the mesh and squeegee is shown in FIG. 4.

Figure 4 shows a screen mesh 406, a screen 408, a screen frame 410, and a squeegee 412.

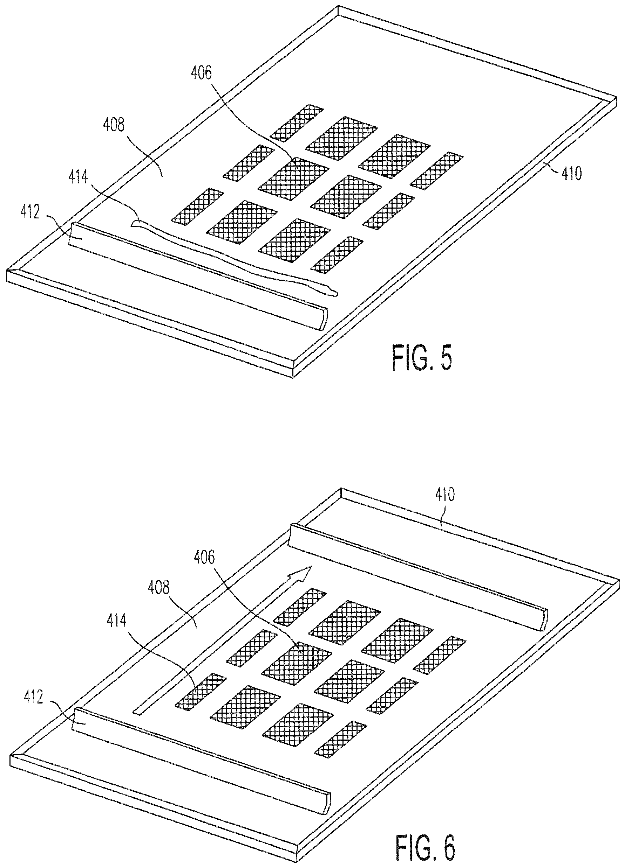

In FIG. 5, the OPD chemical 414 such as the BHJ layer is placed onto the screen, either by automatic control or manually.

In FIG. 6, the squeegee 412 pushes downward onto the screen 408 and is moved forward from a first position to a second position, forcing the chemical into the mesh.

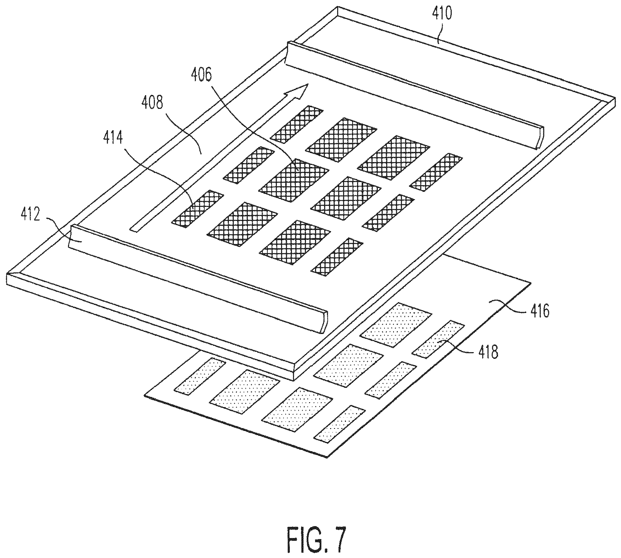

In FIG. 7, the chemical in the mesh 414 contacts the substrate while the squeegee pushes downward and moves across the screen 408, thus transferring the chemical in the form of the pattern 418 onto the substrate 416.

The screen 408 is much lighter than a comparable nozzle for a slot-die coater. The cost of the squeegee 412 as well as the cost of the screen 408 is much less than the cost for a comparable nozzle. As stated earlier, the printed layout can be changed by removing the screen from the tool, either by hand or by a tool suited to the width of the screen, and replaced it with a screen that has the new layout.

The film thickness can be controlled by several conditions, such as the speed in which the squeegee moves across the screen, the mesh count of the screen, and the viscosity of the screen. The quality of the film coat can also be controlled by the methods above, but also by the angle of the squeegee, the hardness of the squeegee, the distance of the screen with the substrate, and the pressure the squeegee applies to the screen as it moves across the screen.

Two known methods for depositing the TC layer are slot-die coating and evaporation. The approach of the present invention of depositing the TC layer using a screen printer over slot-die coating is the same as previously discussed with respect to the active layer. The approach of the present invention of screen printing over evaporation of the TC layer is that the films can be more light transparent. The most common evaporated TC layer material is silver. A silver film blocks over 60% of visible light between the frequencies of 450 nm and 850 nm at its thinnest conductive layer. The screen printer allows the use of other materials such as silver nanowire or transparent conductive ink to act as the TC layer. These materials are more transparent than evaporated silver while still providing sufficient conductivity to ensure the proper functionality of the photo diode array.

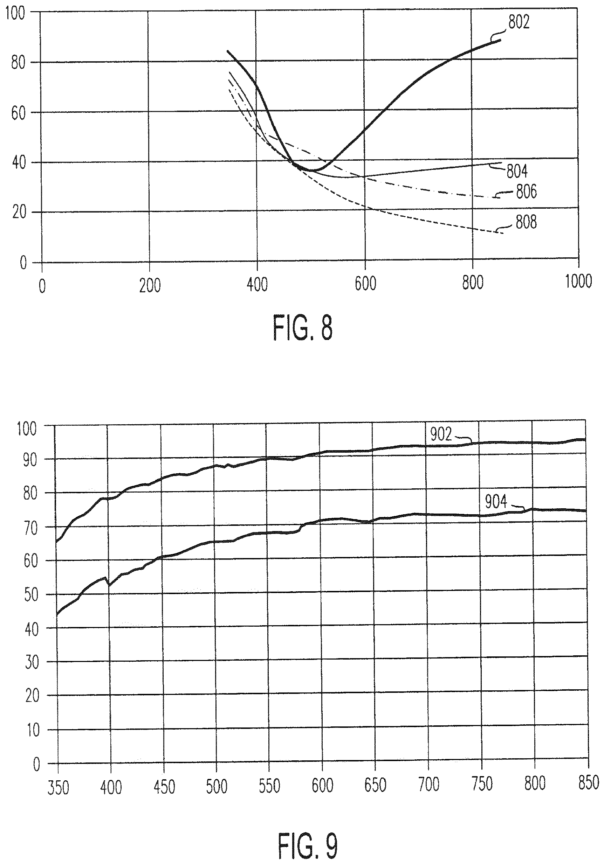

Figure 8 shows the transmissivity of silver for various thicknesses 802, 804, 806, and 808. Trace 802 shows the percentage of light transmission of 6.4 nm thick silver on glass, with respect to light transmission of bare glass. Trace 804 shows the percentage of light transmission of 10 nm thick silver on glass, with respect to light transmission of bare glass. Trace 806 shows the percentage of light transmission of 15 nm thick silver on glass, with respect to light transmission of bare glass. Trace 808 shows the percentage of light transmission of 20 nm thick silver on glass, with respect to light transmission of bare glass.

Slot-die coating allows the use of silver nanowire, transparent conductive ink, or a combination of the two materials. These materials advantageously allow 60% to 90% of the ambient light to pass through the layer and onto the PAL layer. Slot-die coating also allows the ability to use these materials mentioned; however, the disadvantages of slot-die coating are the same as has been previously discussed.

Figure 9 shows the transmissivity of transparent conductive ink films of different formulations. These films were applied using a screen printer. Trace 902 shows the percentage of light transmission of a first sample group of conductive ink on a SiON film, with respect to light transmission of bare glass. Trace 904 shows the percentage of light transmission of a second sample group of conductive ink on a SiON film, with respect to light transmission of bare glass.

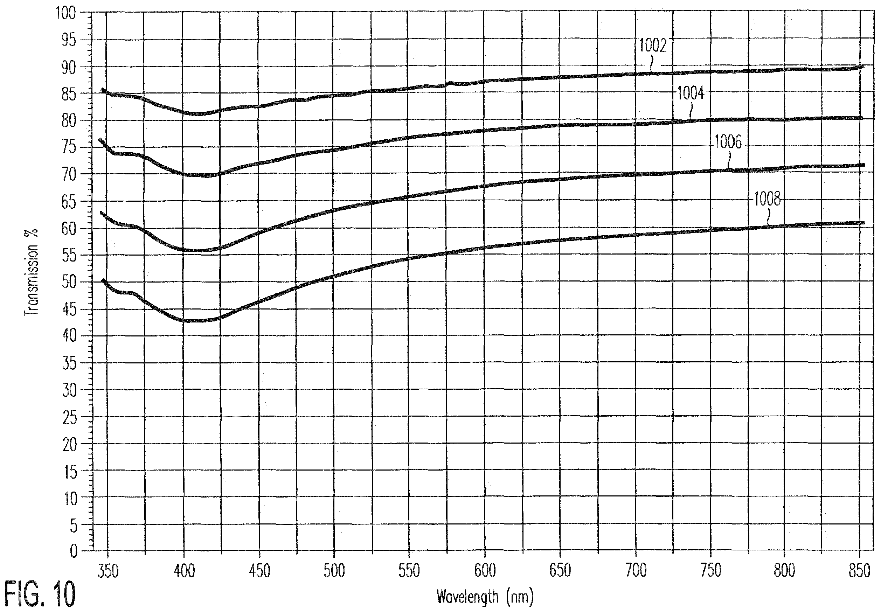

Figure 10 shows the transmissivity of silver nanowire of varying thicknesses and under varying test conditions. These films 1002, 1004, 1006, and 1008 were applied using a screen printer.

In conclusion, screen printing at least one of the active and top contact layers of organic photodiodes in a large sensor array offers several advantages over the prevailing manufacturing methodology. Screen printing equipment is cheaper than slot-die or other methods of deposition, such as inkjet printing. Screen printing allows for an easy product layout change over slot-die coating. Furthermore, the method of the present invention also provides a robust, repeatable, low-cost manufacturing process over the other methods of manufacturing organic photodiodes.

Although the invention has been described and illustrated with a certain degree of particularity, it is understood that the present disclosure has been made only by way of example, and that numerous changes in the combination and arrangement of parts can be resorted to by those skilled in the art without departing from the spirit and scope of the invention, as hereinafter claimed.

## Claims

1. A method of manufacturing an image sensor device comprising:
providing a metalized thin film transistor layer form on a glass substrate;
forming an inter-layer dielectric layer on the metalized thin film transistor layer;
forming a via through the inter-layer dielectric layer;
forming a metal layer on an upper surface of the inter-layer dielectric and within the inter-layer dielectric layer via for contacting the metalized thin film transistor layer;
forming a bank layer on an upper surface of the metal layer and the inter-layer dielectric layer;
forming a via through the bank layer;
forming an electron transport layer on an upper surface of the bank layer and within the bank layer via for contacting an upper surface of the metal layer;
forming a bulk heterojunction layer on an upper surface of the electron transport layer;
forming a hole transport layer on an upper surface of the bulk heterojunction layer; and
forming a top contact layer on an upper surface of the hole transport layer,
wherein either or both of the bulk heterojunction layer and the top contact layer are formed using screen printing.

2. The method of Claim 1, wherein the inter-layer dielectric layer comprises a SiON, SiO2, or SiN layer.

3. The method of Claim 1 or 2, wherein the metal layer comprises a quad-layer metal stack layer.

4. The method of any one of Claims 1 to 3, wherein the bank layer comprises a resin layer.

5. The method of any one of Claims 1 to 4, wherein the electron transport layer comprises a work function tuning layer.

6. The method of any one of Claims 1 to 5, wherein the bulk heterojunction layer comprises a photoactive layer.

7. The method of any one of Claims 1 to 6, wherein the hole transport layer comprises a work function tuning layer.

8. The method of any one of Claims 1 to 7, wherein the top contact layer comprises an anode layer.

9. A method of manufacturing an image sensor device comprising:
providing a thin film transistor on a glass substrate;
forming an organic photodiode coupled to the thin film transistor comprising:
forming an electron transport layer;
forming a bulk heterojunction layer on an upper surface of the electron transport layer;
forming a hole transport layer on an upper surface of the bulk heterojunction layer; and
forming a top contact layer on an upper surface of the hole transport layer,
wherein either or both of the bulk hereojunction layer and the top contact layer are formed using screen printing.

10. The method of Claim 9, wherein the bulk heterojunction layer comprises a photoactive layer.
